# EUROPEAN PATENT APPLICATION

(11) **EP 1 143 781 A1**
(43) Date of publication of application: **10.10.2001**
(21) Application number: 01302727.1
(22) Date of filing: 23.03.2001
(51) Int. Cl.: H05K 9/00, G11B 33/14

(54) **Door opening and closing apparatus**

(30) Priority: 30.03.2000 JP 2000095904
(71) Applicant: Pioneer Corporation, Meguro-ku, Tokyo (JP)
(72) Inventor: Shiraishi, Yoshiki, c/o Pioneer Corporation, Kawagoe-shi, Saitama (JP); Asami, Takashi, c/o Pioneer Corporation, Kawagoe-shi, Saitama (JP); Nakashima, Naoji, c/o Pioneer Corporation, Kawagoe-shi, Saitama (JP); Honda, Manabu, c/o Pioneer Corporation, Kawagoe-shi, Saitama (JP); Ogura, Ikuo, c/o Pioneer Corporation, Kawagoe-shi, Saitama (JP)
(74) Representative: Haley, Stephen

(57) **Abstract**

The door opening and closing apparatus is characterized in that, when the door is closed, the door and the opening portion of the cabinet have the non-contact positional relationship with each other, and by the capacitor structured by a gap formed of respective conductive materials on the surfaces to which the door and the opening portion are opposite each other, the impedance of the gap in the alternating current is lowered.

## Description

The present invention relates to a door opening and closing apparatus used for an information recording and reproducing apparatus of an information recording medium such as a CD, or DVD, or a door opening and closing apparatus used for an electronic apparatus such as a VTR, telecommunication equipment, measuring instrument, control device, or computer network terminal equipment, and particularly, to a door opening and closing apparatus by which the shield effect of unnecessary radiation to other electronic apparatus is intended.

Recently, a computer or portable telephone, or electronic apparatus such as a recording and reproducing apparatus of an optical disk such as a CD or DVD, rapidly spreads into also general families. In these electronic apparatus, because there is a case where electronic parts which radiate an unnecessary electromagnetic wave, are used in the cabinet, it is necessary that the bad influence due to unnecessary radiation of the electromagnetic wave is not exerted on other adjacent electronic apparatus during the operation of the electronic apparatus. Accordingly, in many cases, such the electronic apparatus is formed in such a manner that the whole of parts of the electronic apparatus is covered by a cabinet formed of shield material such as iron plate. For example, when the high frequency electromagnetic wave is radiated from the electronic circuit to the cabinet which shields the electronic circuit, the induced current induced by the electromagnetic wave flows in the shield in the cabinet, and the new electromagnetic field is generated in the cabinet by the induced current. Further, because the electromagnetic field generated in the cabinet acts in the direction to delete the radiated electromagnetic wave, the electromagnetic wave is shielded to the outside of the cabinet by this electromagnetic field.

When an opening portion such as a hole or a disk insertion opening is provided in the cabinet which plays a role of the shield of the electronic circuit, because the induced current has non-uniform current distribution along the opening shape in the vicinity of the opening of the opening portion, it becomes imperfect as compared with other portion that the newly generated electromagnetic field cancels the radiated electromagnetic wave, and the shield effect is lowered. Accordingly, when the electromagnetic wave radiated from the electronic circuit is shielded by the cabinet, it is preferable that the opening portion is not provided in the cabinet so much as possible.

In this connection, when it is necessary that the opening portion is provided in the cabinet of the apparatus for its mechanism, like as the CD reproducing apparatus having the insertion opening for inserting the CD, the electromagnetic wave generated from the electronic parts inside the apparatus is radiated from the opening portion to the outside. Particularly, in a CD changer apparatus into which a magazine, in which a plurality of CDs are accommodated, is inserted, because the opening portion is further larger, there is also a case where the electromagnetic wave generated inside the apparatus is easily directly radiated unnecessarily from the opening of the opening portion to the outside. Accordingly, in such the electronic apparatus, the structure is generally adopted in which an opening and closing door having the conductivity is provided on the surface side of a cabinet portion in the vicinity of the opening of the opening portion, and the radiation amount from the opening portion is suppressed.

Further, the opening and closing door has the role to shield the electromagnetic wave by closing the opening portion when the door is closed, and it is preferable that, in order to make easy the open and close operation by the door opening and closing apparatus provided in the electronic apparatus, the necessary strength is secured and the door is formed in the light weight as much as possible. Accordingly, actually, in many cases, the coating film made of the conductive material is additionally processed by galvanizing or painting on the surface of the molded material molded of the light weighted resin, and the door is formed.

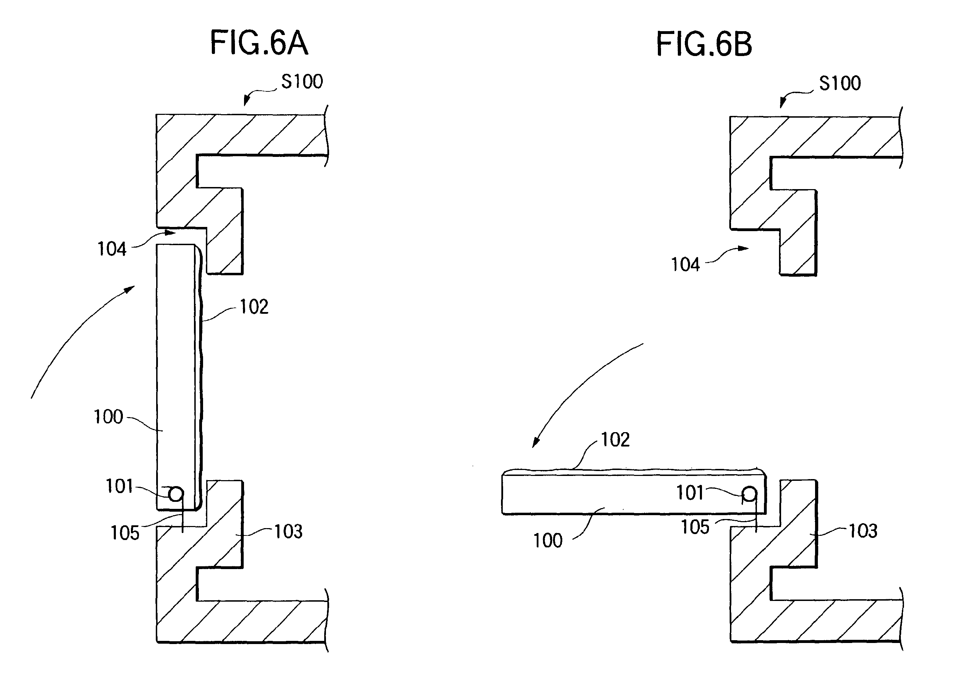

Fig. 6 is a view in which the vicinity of the conventional opening and closing door provided in the electronic apparatus having the opening portion in the cabinet is viewed from the cross section of the opening portion, and Fig. 6A shows the vicinity of the door when the opening of the opening portion is closed, and Fig. 6B shows the vicinity of the door when the opening of the opening portion is opened. In Fig. 6, the cabinet 103 is formed of the conductive material, and for example, has the opening portion 104 in which the rectangular shaped opening is formed.

The door 100 is a molded material formed into the rectangular plate shape slightly smaller than and similar to the shape of the opening portion 104 by using the molding material such as ABS resins, and on both side surfaces on the lower end side, a pair of rotation axes 101 are formed so as to be coaxial to each other by the simultaneous molding. Further, on the rear surface of the door 100, the conductive coating film 102 is formed.

A pair of rotation shafts are rotatably arranged on the front surface side of the opening portion 104 of the cabinet 103 pivotally supported by a bearing (not shown) provided in the cabinet 103, and the door 100 is urged by a spring 105 toward the opening portion 104 and fitted so as to close the opening of the opening portion 104 from the front surface side. Accordingly, when the door 100 is under the closing condition, the conductive coating film 102 formed on the rear surface of the door 100 is pushed onto the opening portion 104 by the force of the spring 105, and brought into electrical contact with it.

In this connection, in the case where the door 100 is pushed to the opening portion 104 in close contact condition, when the restoring force of the spring 105 is the larger, it is the more advantageous, however, in order to smoothly conduct the open and close operation of the door 100, because it is preferable that the restoring force is not so large, the spring 105 is used in such a manner that the restoring force of the spring 105 is set in a appropriate range. Accordingly, the door 100 is structured so that, when the door 100 is in the close condition, the door 100 is pushed to the opening portion 104 by the spring having the appropriate restoring force and brought into contact with it.

Then, when the electromagnetic wave is generated inside the apparatus, the door 100 is closed, and the opening portion 104 is brought into electrical contact with the door 100, and when the door 100 is made equal potential to the cabinet 103 of the portion of the opening portion 104, the opening portion 104 of the cabinet 104 is electrically closed, and the electromagnetic wave is shielded to the outside.

However, because it is difficult that the conductive coating film 102 to coat the door 100 is accurately formed in the flat surface over the whole surface to be brought into contact with the opening portion 104, and in particular, in the electronic apparatus having a large opening such as a magazine type CD changer, because it is necessary that the surface of the conductive coating film to coat the door is accurately formed into the flat surface over the wide range by an amount of an increased area of the opening of the opening portion, when the opening is closed by urging the door 100 by the spring 105, it is difficult to make the conductive coating film 102 to coat the door 100 fully closely bring into contact with the opening portion. As a result, in many cases, the conductive coating film 102 of the door 100 and the cabinet 103 of the portion of the opening portion are brought into contact with each other only at a slight contact portion as shown in Fig. 6.

When the contact of the conductive coating film 102 of the door 100 with the cabinet 103 of the portion of the opening portion 104 is smaller, the impedance between the conductive coating film 102 of the door 100 and the cabinet 103 of the portion of the opening portion 104 is higher than that of the portion of the cabinet 103 of the other portion, accordingly, because the distribution of the induced current induced in the door 100 and cabinet 103 by the electromagnetic wave generated inside the apparatus becomes non-uniform in the contact portion, there is sometimes a case where the new electromagnetic field is generated in the portion and radiated to the outside. As a result, it is difficult to fully shield the electromagnetic wave to the outside of the apparatus.

Therefore, conventionally, the measures in which, for example, an elastic conductive cushion material is nipped between the door 100 and the opening portion 104, or the area of the door 100 is formed larger than that of the opening portion 104, and when the door 100 is closed, the shape of the both is increased so that the contact area of the conductive coating film 102 of the door 100 with the cabinet casing 103 is increased, are considered, and the impedance of the contact portion of the conductive coating film 102 of the door 100 with the cabinet 103 is lowered.

However, even in the above case, there is a problem that, as the number of the open and close operation of the door is increased, because an area contacting with each other is changed, the impedance of the contact portion is not stabilized. Particularly, because it is necessary that the door 100 and the opening portion 104 are directly brought into contact with each other when the door is closed, the protective film of such as the finishing paint, or the paint film for the visual design can not be formed on the surface. Accordingly, in the electronic apparatus using the door opening and closing apparatus in which the door 100 is rotated to the front surface side of the apparatus, there is a problem that the contact portion is in the bared condition, and the portion is oxidized and deteriorated, or damaged by a scratch, and when the door 100 is closed, the portion can not be brought into full contact with the conductive coating film 102 of the door 100. Further, when the door is opened, because the opening portion on which the finishing painting is not conducted, is exposed on the surface, there is a restriction for the design in the vicinity of the opening portion.

In view of the foregoing problems, the present invention is attained, and an object of the present invention is to provide a door opening and closing apparatus which is used for the electronic apparatus and by which the unnecessary radiation by the electromagnetic wave can be easily and fully shielded by a simple structure.

The invention of the first aspect is characterized in that:
in a door opening and closing apparatus which has an opening portion provided in a cabinet, and a door to open and close the opening portion by a rotation mechanism, the primary surface of the door and the surface of the cabinet are formed of conductive material; when the door is closed, the door and the opening portion have a non-contact positional relationship with each other; and opposite surfaces to which the door and the opening portion are opposed each other, are respectively formed of the conductive material.

According to the invention described in the first aspect, when the door is closed by the rotation mechanism, the door and the opening portion has a non-contact positional relationship with each other, and by the conductive material formed on the surfaces to which the door and the opening portion are opposed each other, a capacitor is formed, and when the high frequency electromagnetic wave is radiated from the inside of the apparatus to the cabinet and door, because the capacitor is low impedance to the high frequency electromagnetic wave, the potential on each of conductive materials of the cabinet and door becomes equal in the high frequency, and accordingly, the current distribution of the induced current flowing in each of conductive materials of the cabinet and door becomes equal. Accordingly, in the casing cabinet portion in the vicinity of the opening of the opening portion and door, because the electromagnetic wave is hardly generated locally, the unnecessary radiation by the electromagnetic wave can be easily shielded to the outside of the apparatus.

Further, the invention of the second aspect is, in the door opening and closing apparatus described in the first aspect, characterized in that it has a positioning member for positioning the door and the opening portion so that the positional relationship of the opposed surfaces is kept constant.

According to the invention described in the second aspect, when the door is closed, because, by the positioning member which the rotation mechanism has, a gap formed between the conductive material formed on the surface of the door and the conductive material formed on the surface of the opening portion is stably kept constant, by the capacitance of the capacitor structured by the conductive material of the door and the conductive material of the cabinet casing, which are opposed to each other through the gap, the stable low impedance can be formed to the high frequency electromagnetic wave radiated from the inside of the apparatus to the cabinet casing and door. As a result, when the door is closed, the potential on each of conductive materials of the cabinet casing and door is equal to each other, accordingly, the current distribution of the induced current flowing through each of conductive materials of the cabinet casing and door is equal to each other. Accordingly, the electromagnetic wave is hardly generated locally in the casing cabinet portion in the vicinity of the opening of the opening portion and door, and as a result, the unnecessary radiation by the electromagnetic wave can be easily shielded to the outside of the apparatus.

Further, the invention described in the third aspect, in the door opening and closing apparatus described in the first aspect or the second aspect, is characterized in that: the door has an almost rectangular shape, and the surfaces in the vicinity of the end portions which are almost in a parallel relationship to each other, are formed of conductive material, and in the opening portion, the surfaces having an opposite relationship to the vicinity of the end portions when the door is closed, are formed of conductive material.

According to the invention described in the third aspect, when surfaces in the vicinity of the end portions which are almost in a parallel relationship to each other, of the rectangular-shaped door, are formed of conductive material, and the surfaces of the opening portion, having an opposite relationship to the vicinity of the end portions when the door is closed, are formed of conductive material, the impedance in the perpendicular direction to the end portion can be lowered.

In the Drawings:

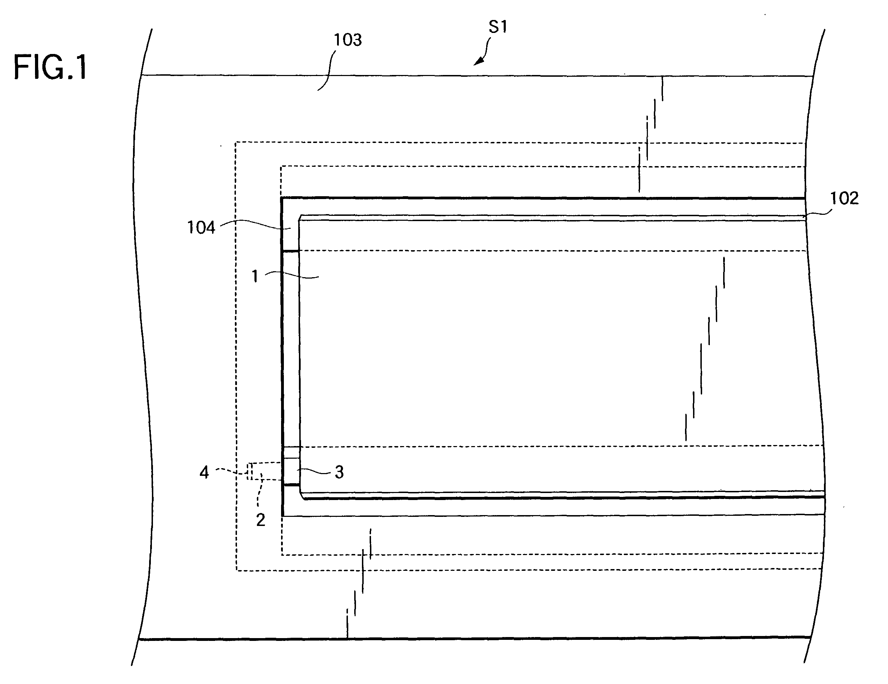

Fig. 1 is an outline view of a main portion in which a portion (almost left half) of a door of a door opening and closing apparatus S1 used for an electronic apparatus according to the present invention is viewed from the surface side of the electronic apparatus.

Figs . 2A and 2B are view in which a door of the door opening and closing apparatus S1 is viewed from the cross section of an opening portion of a cabinet.

Figs . 3A and 3B are view showing a door opening and closing apparatus S2 and a door opening and closing apparatus S3 in another embodiment of the present invention.

Fig. 4 is a view showing a door opening and closing apparatus S4 in another embodiment of the present invention.

Fig. 5 is a view showing an example of a conductive coating film 102 formed on the surface of a portion of the primary surface of the door 1 of the door opening and closing apparatus of the present invention.

Figs. 6A and 6B are view in which the vicinity of the conventional opening and closing door provided in the electronic apparatus having an opening portion in a cabinet is viewed from a cross section of the opening portion.

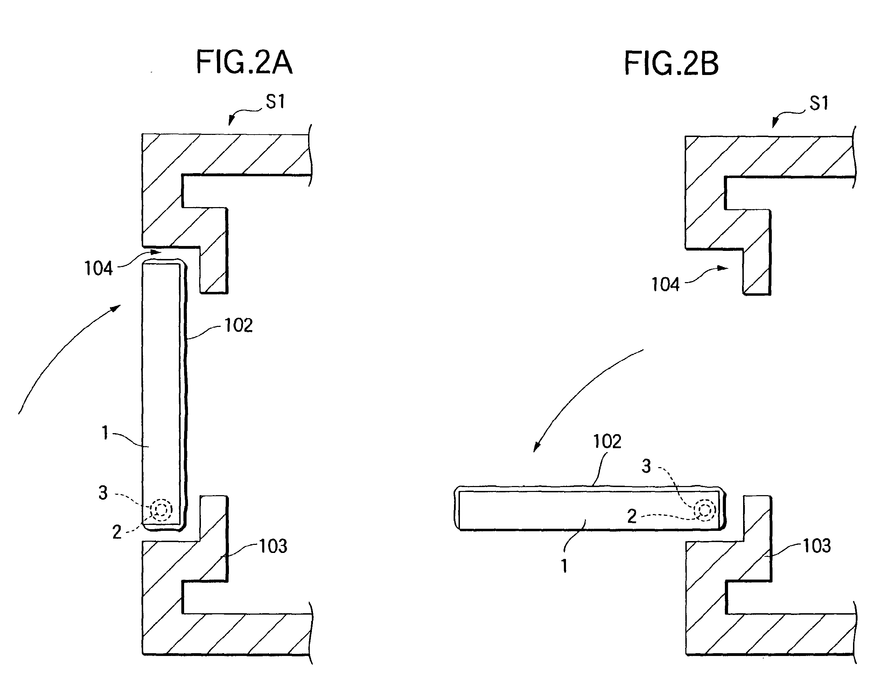

Next, referring to the drawing, a preferred embodiment of the present invention will be described. Fig. 1 is an outline view of a main portion in which a portion of a door (almost left half) of a door opening and closing apparatus S1 used for an electronic apparatus of the present invention is viewed from the front surface side of the electronic apparatus . Further, Fig. 2 is a view in which the door of the door opening and closing apparatus S1 is viewed from the cross section of an opening portion of a cabinet. Fig. 2A shows the door when the opening portion is closed, and Fig. 2B shows the door when the opening portion is opened. In this connection, in each of the structure of the door opening and closing apparatus S1 in Fig. 1 and Fig. 2, the component equivalent to the conventional door opening and closing apparatus S100 is denoted by the same numerical symbol, and herein, because its explanation is duplicated, the explanation will be omitted.

The door opening and closing apparatus S1 has an opening 104 provided in a cabinet 103 formed of conductive materials, and a door 1, and a rotation mechanism, which will be described later, to open and close the door 1. The door 1 is, for example, a rectangular plane-shaped molded material formed by using a mold material such as ABS resins, and on both side surfaces on the lower end side, a cylindrical rotation axis 2 to rotatably support the door 1 to the opening portion 104, and a stopper 3 to determine the positional relationship of the opening portion 104 with the door 1, are provided so as to be coaxial.

Further, as shown in Fig. 2, on the upper and lower ends of the door 1 and the surface of the rear surface of the door 1 opposed to the inside of the apparatus, a conductive coating film 102 formed of the conductive material is formed. The door 1 is supported on the front surface side of the opening portion 104 of the cabinet 103 when a pair of rotation axes 2 are engaged in bearings 4 provided in the cabinet 103 and pivotally supported. The rotation mechanism is formed by the bearings 4, rotation axes 2 which are engaged in the bearings 4 and pivotally supported, and the stopper 3. The door 1 can open and close the opening portion 104 of the cabinet 103 by the rotation mechanism.

Further, as shown in Fig. 2A, when the door is closed, the door 1 is positioned to the opening portion 104 by the rotation mechanism, and accommodated in the opening portion 104 so as to close the opening portion 104, and held to be almost perpendicular to the opening portion 104 in the non-contact positional relationship with the opening portion 104 by a lock mechanism, not shown. According to the above description, when the door 1 is closed, the door 1 and the opening portion 104 are opposed to each other, and a non-contact predetermined gap is formed.

As a result, a capacitor is formed by a predetermined gap formed between the conductive coating film 102 of the surface of the door 1 and the conductive material on the surface of the cabinet 103 of a portion of the opening portion 104 opposing to it. Accordingly, when the door 1 is closed, the conductive coating film 102 of the door 1 and the opening portion 104 are connected to each other through this capacitor.

The capacitance of the capacitor is proportional to the facing area of the conductive coating film 102 of the door 1 to the surface of the opening portion 104, which are opposed to each other, and proportional to the dielectric constant of the gap, and is inversely proportional to the distance between the conductive coating film 102 of the door 1 and the surface of the cabinet 103 of a portion of the opening portion 104 opposing to it. Further, the impedance of the capacitor in the alternating current, is inversely proportional to the capacitance of the capacitor and the alternating current frequency.

Accordingly, when the area of the conductive coating film 102 forming the capacitor and the distance between the conductive coating film 102 and the opening portion 104 opposing to it is adjusted and the gap is formed, the impedance value in the alternating current can be sufficiently lowered by the capacitor, to the high frequency electromagnetic wave radiated when the door 1 is closed. Particularly, when the capacitor is formed in the vicinity of the upper end portion and the lower end portion of the door which are in almost the parallel relationship to each other, the impedance value in the upper and lower direction can be sufficiently lowered. Further, when the door 1 is closed, because the door 1 and the opening portion 104 are kept to a predetermined gap by the positioning member of the rotation mechanism and the lock mechanism, the capacitor is stably formed with a predetermined capacitance.

As a result, when the door 1 is closed, in the case where the high frequency electromagnetic wave is radiated from the electronic circuit to the cabinet 103 and the door 1, because the capacitor is the stable low impedance to the frequency of the electromagnetic wave, the conductive coating film 102 of the door 1 and the cabinet 103 of a portion of the opening portion are in the continuity condition to the electromagnetic wave.

As a result, the surface of the cabinet 103 and the surface of the conductive coating film 102 of the door 1 connected through the capacitor become the equal potential, and accordingly, the current distribution of the induced current flowing through the cabinet 103 and the conductive coating film 102 of the door 1 becomes equal. Accordingly, the electromagnetic wave is hardly generated locally in the casing cabinet 103 portion in the vicinity of the opening of the opening portion 104 and the door 1, as a result, the electromagnetic wave can be easily shielded to the outside of the apparatus.

In this connection, in the above embodiment, when the door 1 is opened, the inside of the cabinet 103 is opened to the outside by the opening portion 104, and when the power source of the electronic circuit block radiating the electromagnetic wave is structured to be cut off interlocking with the opening operation of the door 1, because the electromagnetic wave is not radiated from the inside of the apparatus when the door 1 is opened, the electromagnetic wave is not radiated from the opening portion 104 to the outside of the apparatus.

Further, in the case where the electronic apparatus is a disk reproducing apparatus, when the door 1 is opened, because it is a time when the recording medium such as a disk is replaced, it is not necessary that the apparatus reproduces the recording medium, even when the power source of the electronic circuit block radiating the electromagnetic wave is cut off, there occurs no disadvantages for the user.

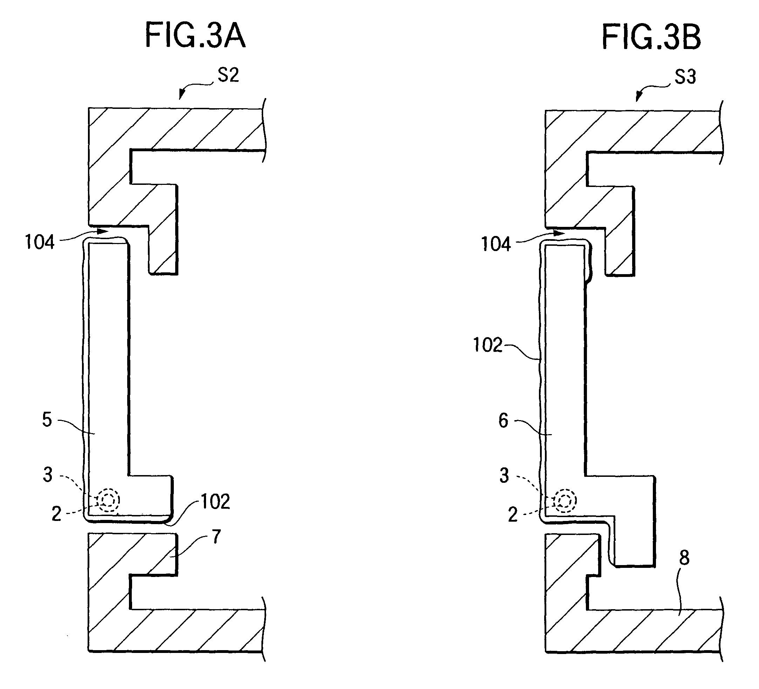

In this connection, in the above door opening and closing apparatus S1, the door 1 is structured by using the rectangular plane-shaped molded material formed by using the molding material such as ABS resins, however, the shape of the door in the present invention may not always be the rectangular plane shape, but, for example, in each of examples of the door opening and closing apparatus in other embodiments shown in Fig. 3, when it has the structure in which, as the door 5 of the door opening and closing apparatus S2 shown in Fig. 3A, and the door 6 of the door opening and closing apparatus S3 shown in Fig. 3B, the door can be opened and closed by the rotation mechanism, and when the door is closed, the opening portion 104 and the vicinity of the opening portion 104 are closed by the door under the condition that these have the gap by which these are in no contact with the door, any shape may also be allowable.

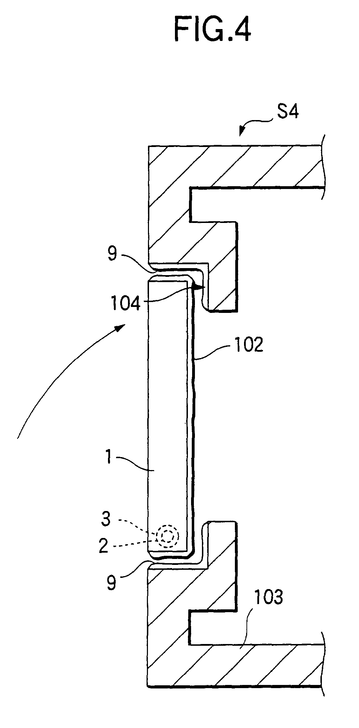

Further, in the above door opening and closing apparatus S1, the conductive coating film 102 is formed on the upper and lower ends of the door 1 and the surface facing the inside of the apparatus, and when the door 1 is closed, the capacitor is formed by forming a gap between the conductive coating film 102 of the door 1 and surface of the cabinet 103 of a portion of the opening portion 104, however, the present invention is not limited to this, but, for example, as shown in the door opening and closing apparatus S4 in the other embodiment shown in Fig. 4, the film 9 such as the paint film for the design or the protection film is formed on the surface of the cabinet 103 of a portion of the opening portion 104 facing the conductive coating film 102 of the door 1, and the capacitor may be formed by forming a gap between the conductive coating film 102 of the door 1 and the film 9.

That is, when the film 9 is the protection film, because the conductive material of the surface of the cabinet 103 of a portion of the opening portion 104 is protected from the deterioration due to the oxidation or the damage due to the scratch, by the film 9, accordingly, the surface of the conductive material of the surface of the cabinet 103 of the opening portion 104 becomes stable. In this connection, in this case, when the door 1 is closed, the conductive coating film 102 of the door 1 and the conductive material of the opening portion 104 opposing to it, become both electrodes of the capacitor, and because this becomes a condition that the film 9 is formed between these electrodes, when the dielectric constant and the thickness of the material of the film are appropriately adjusted, the capacitance of the capacitor can be adjusted.

Further, when the film 9 plays the role of the paint film for the design, particularly, in the door opening and closing apparatus having the structure in which the door 1 is opened and closed toward the front surface side of the apparatus, to the opening portion 104 by the rotation mechanism, when the film 9 is formed by painting the paint of the desired color or material in a desired pattern, the visual design of the opening portion 104 when the door 1 is opened, can be freely set. In this connection, the film 9 may also be a film having the role of both the protection film and the paint film for the design in common.

Further, in each of embodiments described above, the conductive material is formed on the surface of the door 1 by forming the conductive coating film 102 on the upper and lower ends and rear surface of the door 1, however, in the present invention, the conductive material may be formed on any one of the surface of the front side and the surface of the rear side, which are at least the primary surface of the door 1. Further, when the cabinet 103 and the opening portion 104 are formed of the insulation material such as resins, at least any one surface of the front surface and the rear surface may be formed of the conductive material.

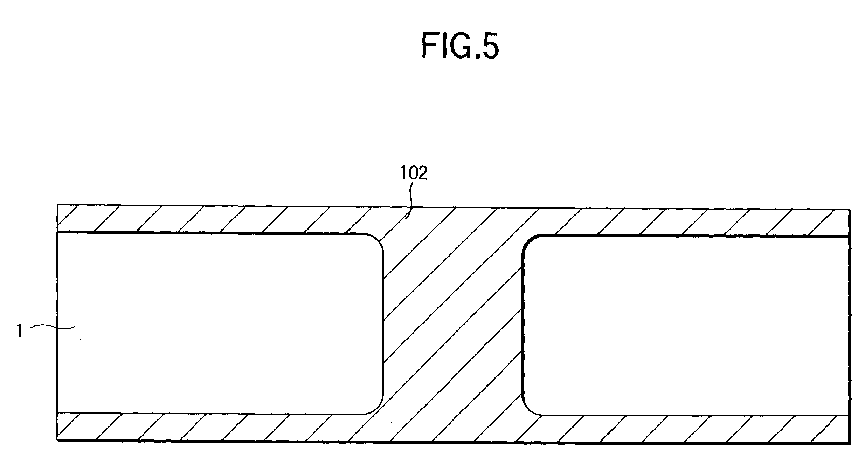

In this connection, in the present invention, it is not necessary that the conductive material is not always formed on the whole surface of the door 1, accordingly, the conductive material may be formed in such a degree that the electromagnetic wave radiated from the opening portion does not influence on the other electronic apparatus. That is, because the electromagnetic wave radiated from the opening portion of the electronic apparatus is so much decreased as, generally, the opening shape of the no-shielded opening portion is smaller, when the conductive material is formed on a portion of the surface of the door, the opening shape of the no-shielded opening portion is made a small size, and the influence of the radiation of the electromagnetic wave onto the other electronic apparatus may be decreased. In this manner, an example of the conductive material formed on the surface of a portion of the primary surface of the door is shown in Fig. 5.

Fig. 5 is a view showing an example of the conductive coating film 102 formed on the surface of a portion of the primary surface of the door 1 of the door opening and closing apparatus of the present invention.

In Fig. 5, the conductive coating film 102 is formed on the surface of the primary surface on the rear surface side of the door 1 in the pattern shown by the slanting line portion. As a result, the door 1 is formed by the small opening shape in which the opening portion not-shielded by the conductive coating film 102 is divided into two.

Further, in each of embodiments described above, the cabinet is formed of the conductive material, thereby, the surface of the opening portion is the conductive material, however, resins may be used for the cabinet, and in this case, when the surface of a portion of the opening portion is formed of the conductive material, for example, in such a manner that the conductive coating film is formed on the surface of a portion of the opening portion opposed to the door through the gap, when the door is closed, the capacitor may be structured by the door and the surface of a portion of the opening portion and the gap.

Further, because the vicinity of the end portion of the rotation axis 2 side of the door 1 can be hardly seen from the outside of the apparatus when the door is opened, and is hardly damaged, the vicinity of the lower end portion of the door having the rotation axis 2 and the opening portion 104 are structured so that the conductive materials are directly brought into contact with each other when the door is closed, and the upper end portion of the door 1 may be structured as the capacitor described above.

Further, in the present embodiment, an example in which the conductive material is formed on the upper and lower portions of the door 1, is described, however, the present invention is not limited to this, but, it may be structured so that the conductive materials are formed on the left and right end portions of the door 1.

### (Effect of the Invention)

According to the invention of the first aspect, when the door is closed by the rotation mechanism, the door and the opening portion have a non-contact positional relationship with each other, and because a capacitor is formed by the conductive materials formed on the surfaces of the door and the surface of the opening portion, when the high frequency electromagnetic wave is radiated from the inside of the apparatus to the cabinet and door, because the capacitor is low impedance to the high frequency electromagnetic wave, the potential on each of conductive materials of the cabinet and door becomes equal, and accordingly, the current distribution of the induced current flowing in each of conductive materials of the cabinet and door becomes equal. Accordingly, in the casing cabinet portion in the vicinity of the opening of the opening portion and the door, because the electromagnetic wave is hardly generated locally, the unnecessary radiation by the electromagnetic wave can be easily shielded to the outside of the apparatus.

Further, according to the invention of the second aspect, when the door is closed, because, by the positioning member which the rotation mechanism has, a positional relationship of the conductive material formed on the surface of the door to the conductive material formed on the surface of the casing cabinet portion on the periphery in the vicinity of the opening of the opening portion is stably kept constant, the capacitance of the capacitor structured by the conductive material of the door and the conductive material of the cabinet casing, which are opposed to each other through the gap, becomes a capacitance in which the stable low impedance can be formed to the high frequency electromagnetic wave radiated from the inside of the apparatus to the cabinet casing and door. As a result, when the door is closed, the potential on each of conductive materials of the cabinet casing and door is equal to each other, accordingly, the current distribution of the induced current flowing through each of conductive materials of the cabinet casing and door is equal to each other. Accordingly, the electromagnetic wave is hardly generated locally in the casing cabinet portion in the vicinity of the opening of the opening portion and door, and as a result, the unnecessary radiation by the electromagnetic wave can be easily shielded to the outside of the apparatus.

According to the invention described in the third aspect, when surfaces in the vicinity of the end sides which are almost in a parallel relationship to each other, of the rectangular shaped door are formed of conductive material, and the surfaces of the opening portion, having an opposite relationship to the vicinity of the end sides when the door is closed, are formed of conductive material, the impedance in the perpendicular direction to the end side can be lowered.

## Claims

1. A door opening and closing apparatus comprising:
an opening portion provided in a cabinet, and
a door to open and close said opening portion by a rotation mechanism, wherein
the primary surface of said door and the surface of said cabinet are formed of conductive material;
when said door is closed, said door and said opening portion have a non-contact positional relationship with each other; and
opposite surfaces to which said door and said opening portion are opposed each other, are respectively formed of the conductive material.

2. The door opening and closing apparatus according to Claim 1, wherein
said rotation mechanism includes a positioning member for positioning said door and said opening portion so that the positional relationship of the opposed surfaces is kept constant.

3. The door opening and closing apparatus according to Claim 1, wherein
said door has an almost rectangular shape, and the surfaces in the vicinity of the end portions which are almost in a parallel relationship to each other, are formed of conductive material, and
in the opening portion, the surfaces having an opposite relationship to the vicinity of the end portions, when said door is closed, are formed of conductive material.

4. The door opening and closing apparatus according to Claim 2, wherein
said door has an almost rectangular shape, and the surfaces in the vicinity of the end portions which are almost in a parallel relationship to each other, are formed of conductive material, and
in the opening portion, the surfaces having an opposite relationship to the vicinity of the end portions, when said door is closed, are formed of conductive material.
